# EUROPEAN PATENT SPECIFICATION

(11) **EP 0 460 223 B1**
(45) Date of publication and mention of the grant of the patent: **25.09.1996**
(21) Application number: 91900344.2
(22) Date of filing: 27.11.1990
(51) Int. Cl.: H04B 3/00, H01T 4/06

(54) **BOARD FOR SURGE ABSORBING DEVICE OF COMMUNICATION LINE**
KARTE FÜR EINE ÜBERSPANNUNGSAUFNAHMEVORRICHTUNG EINER ÜBERTRAGUNGSLEITUNG
CARTE POUR DISPOSITIF ABSORBANT LES SURTENSIONS SUR UNE LIGNE DE COMMUNICATIONS

(30) Priority: 27.12.1989 JP 149365/89 U; 27.12.1989 JP 149366/89 U; 27.12.1989 JP 149367/89 U
(43) Date of publication of application: 11.12.1991
(73) Proprietor: MITSUBISHI MATERIALS CORPORATION, Chiyoda-ku Tokyo (JP)
(72) Inventor: ITO, Takaaki Mitsubishi Materials Corporation, Chichibu-gun, Saitama-ken 368 (JP); KURASAWA, Koichi Mitsubishi Materials Corporation, Chichibu-gun Saitama-ken 368 (JP); SARUWATARI, Nobuya Mitsubishi Materials, Chichibu-gun Saitama-ken 368 (JP); TANAKA, Yoshiyuki Mitsubishi Materials, Chichibu-gun Saitama-ken 368 (JP)
(74) Representative: Casalonga, Axel
(86) International application number: JP9001534
(87) International publication number: WO9110291

(56) References cited:
- DE-A- 2 032 994
- DE-A- 3 606 287
- DE-U- 8 808 743
- JP-A- 5 843 635

## Description

This invention relates to a circuit board for a surge absorber for use with an apparatus which is connected to communication lines of a telephone exchange, a telephone set, a facsimile, a MODEM or the like.

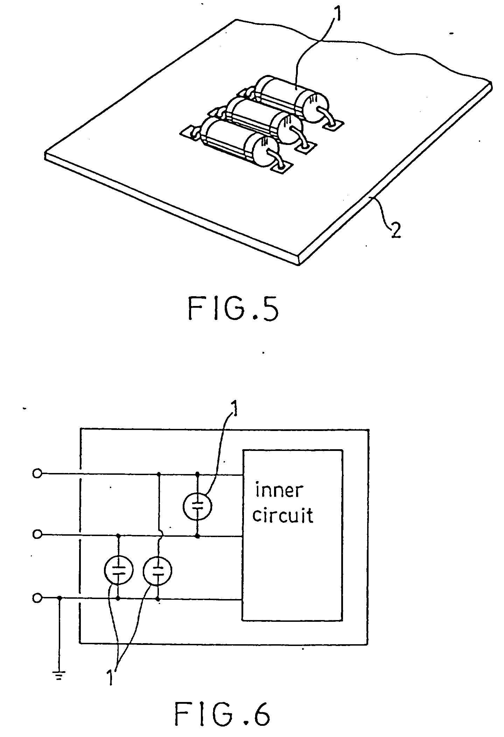

It is a common practice to use, in order to protect a telephone exchange, a telephone set, a facsimile, a MODEM or the like from an induction lightning surge approaching into communication lines, surge absorbing elements 1 between individual lines and between individual lines and the ground as shown in FIG. 6. In this instance, the three surge absorbing elements 1 are mounted on an internal printed circuit board (circuit board for a surge absorber) 2 of a telephone exchange, a telephone set, a facsimile, a MODEM or the like as shown in FIG. 5.

When the three surge absorbing elements are mounted on the circuit board 2 for a surge absorber for a telephone exchange, a telephone set, a facsimile, a MODEM or the like, conventionally they are disposed in a plane as shown in FIG. 5. Since a high voltage approaches the surge absorbing elements 1, if it is attempted to reduce the space for the installation of them, then a distance between and a dielectric strength and so forth of wiring patterns of the circuit board 2 for a surge absorber must be taken into consideration, and there is a limitation in reduction of the installation space for the surge absorbing elements 1.

DE-A-2 032 994 discloses a holding circuit board having a plurality of surge absorbing elements mounted on one surface thereof connected through a wire pattern disposed on the other surface of said holding circuit board and coated with an insulating varnish. Terminals for mounting said holding circuit board on a circuit board are also provided on said holding circuit board.

It is an aim of the present invention to significantly reduce the installation space for a group of surge absorbing elements on a circuit board for a surge absorber.

It is another aim of the present invention to further improve the dielectric strength between wiring patterns of an holding circuit board on which the surge absorbing elements are disposed.

It is a further aim of the present invention to improve the insulating property and the voltage resisting property of the entire holding circuit board.

As claimed, the invention proposes a circuit board in combination with a separate holding circuit board, said holding circuit board having a plurality of surge absorbing elements thereon connected through a wire pattern provided on one surface of said board and terminals for mounting said holding circuit board on said circuit board. According to the invention, the holding circuit board is mounted uprightly on said circuit board and only spaces between individual wiring patterns of the holding circuit board are at least partially coated with an insulating material.

In particular, while a plurality of surge absorbing elements are conventionally disposed in a plane on a circuit board for a surge absorber, according to the present invention, surge absorbing elements are disposed in a three-dimensional arrangement using a predetermined holding circuit board separate from a circuit board for a surge absorber and it is possible to reduce the mounting area of the group of surge absorbing elements on the circuit board for a surge absorber.

If spaces between individual wiring patterns of the holding circuit board are partially or entirely coated with an insulating material, then the dielectric strength between the individual wiring patterns can be improved. Accordingly, if the dielectric strength is equal, then the distances between the individual wiring patterns can be reduced and it is possible to reduce the area of the circuit board.

As claimed, the invention proposes also a circuit board in combination with a separate holding circuit board, said holding circuit board having a plurality of surge absorbing elements mounted on one surface thereof connected through a wire pattern and terminals for mounting said holding circuit board on said circuit board. According to the invention, the holding circuit board is mounted uprightly on said circuit board and the wire pattern is provided on both surfaces of said holding circuit board, whereby the mounting area of surge absorbing elements on the circuit board is reduced.

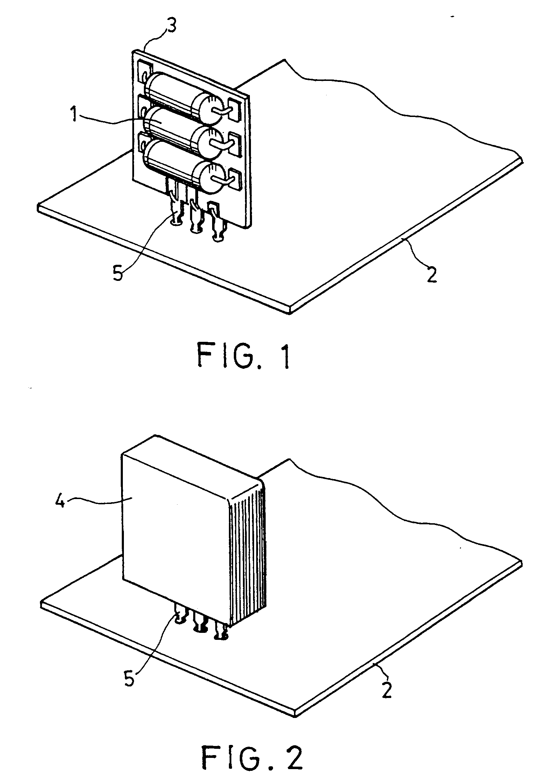

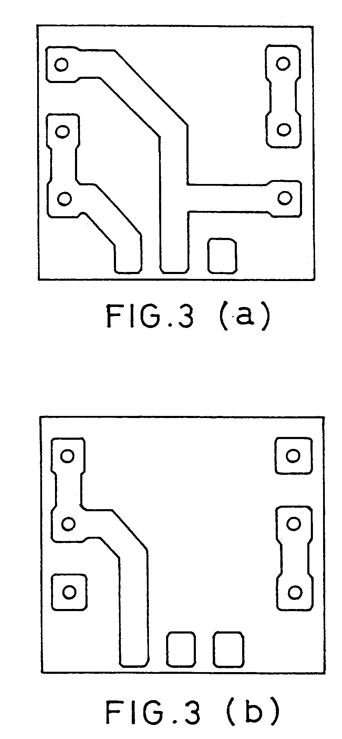

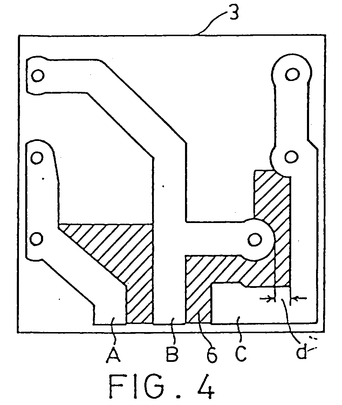

FIG. 1 is a perspective explanatory view of an embodiment of the present invention; FIG. 2 is a perspective explanatory view of another embodiment of the present invention; FIGS. 3 are plan views of a first embodiment of a holding circuit board which is used in the present invention, and FIG. 3(a) shows a front surface while FIG. 3(b) shows a rear surface; FIG. 4 is a plan view of a second embodiment of a holding circuit board which is used in the present invention; FIG. 5 is a perspective explanatory view of a conventional example; and FIG. 6 is an example of a wiring diagram of surge absorbing elements.

### Embodiment - a

### (1) First Embodiment of Holding Circuit Board

A first embodiment of a holding circuit board 3 for surge absorbing elements 1 which is used in the present invention is shown in FIGS. 3. FIG. 3(a) shows a front surface (the side on which surge absorbing elements are to be mounted) while FIG. 3(b) shows a rear surface, and wiring patterns are individually provided on the surfaces. FIG. 1 is a first embodiment of the present invention, and the three surge absorbing elements 1 are mounted on the holding circuit board 3 of FIGS. 3.

In particular, the three surge absorbing elements 1 are disposed on the holding circuit board 3 for the surge absorbing elements 1, and the holding circuit board 3 is provided uprightly on a circuit board 2 for a surge absorber by way of terminals 5.

While the surge absorbing elements 1 are conventionally disposed in a plane as shown in FIG. 5, where they are connected in a three-dimensional arrangement to the circuit board 2, the mounting area of the surge absorbing elements 1 on the circuit board 2 can be reduced. The holding circuit board 3 used in the present embodiment is a pattern-wired glass epoxy circuit board (15.0 x 13.0 x 0.8 mm), and the minimum pattern distance is 1.0 mm.

The three surge absorbing elements 1 (diameter: 3.3 mm, length: 7 mm, discharge starting voltage: 300 volts) of the micro-gap type are mounted on the holding circuit board 3.

As a result, the circuit board mounting area is:

| | |
|---|---|
| Present Invention: | 67.5 (15 x 4.5) mm² |
| Conventional Example: | 144 (12 x 12) mm² |

In particular, the mounting area of the surge absorbing elements on the circuit board for a surge absorber is smaller than one half that of the conventional example.

### (2) Second Embodiment of Holding Circuit Board

A second embodiment of the holding circuit board 3 for the surge absorbing elements 1 which is used in the present embodiment is shown in FIG. 4. The circuit board 3 is a glass epoxy circuit board (13.1 x 12.4 x 0.8 mm), and the minimum pattern wire distance is 0.3 mm and portions in the neighborhood of portions at which the pattern wire distance is particularly small are coated with an insulating material 6.

The three surge absorbing elements 1 (diameter: 3.3 mm, length: 7 mm, discharge starting voltage: 300 volts) of the micro-gap type are mounted on the holding circuit board 3 as shown in FIG. 1, and the holding circuit board 3 is mounted on the circuit board 2 by way of the terminals 5.

In the present example, the mounting area of the surge absorbing elements 1 on the circuit board 2 could have been reduced in the following manner.

| | |
|---|---|
| Present Invention: | 59.0 (13.1 x 4.5) mm² |
| Conventional Example: | 144 (12 x 12) mm² |

In particular, the mounting area of the surge absorbing elements on the circuit board for a surge absorber is smaller than one half the conventional example.

In order to compare the insulating strength of the circuit board 3 with that of the conventional example, the following surge application examination was conducted.

| | |
|---|---|
| Applied Surge: | (1.2 x 50) µsec - 10 kV |
| Applied Location: | between terminals B - C |
| As a result, | |

| | Insulating Material | Dielectric Breakdown |
|---|---|---|
| The Invention | Present | No |
| Conventional Example | Absent | Appeared at d between Pattern Wires |

is obtained, and an improvement in dielectric strength can be noticed.

It is to be noted that the insulating material 6 is not particularly limited if it has a high insulating performance.

### Embodiment - b

Another embodiment of the present invention is shown in FIG. 2. In the present embodiment, the three surge absorbing elements 1 are mounted on the first embodiment of the holding circuit board 3 described hereinabove, and portions of the holding circuit board 3 except portions of the terminals 5 are accommodated in a case 4 of an epoxy or PBT (Poly Butylene Terephthalate) resin and the holding circuit board 3 is provided uprightly on the circuit board 2 for a surge absorber by way of the terminals 5. Where the holding circuit board 3 is accommodated in the case 4 in this manner, even if a surge absorbing element should be destroyed by a surge, scattering thereof can be prevented.

It is to be noted that the material of the case 4 is not particularly limited if it has a high insulating performance.

According to the present invention, when surge absorbing elements are to be mounted on a circuit board for a surge absorber, it is possible to reduce the mounting area thereof to about one half or below one half that of a conventional apparatus, and further, since the dielectric strength between wiring patterns on a holding circuit board for the surge absorbing elements can be improved, the areas of the holding circuit board and the circuit board for a surge absorber can be reduced. Further, if the area of the circuit board for a surge absorber is equal, then a greater number of parts than ever can be mounted.

Further, mounting of the surge absorbing elements onto the circuit board for a surge absorber only requires mounting of the holding circuit board on which the surge absorbing elements are provided, and the construction is easy.

## Claims

1. A circuit board in combination with a separate holding circuit board, said holding circuit board (3) having a plurality of surge absorbing elements (1) thereon connected through a wire pattern provided on one surface of said board and terminals (5) for mounting said holding circuit board on said circuit board (2), characterized in that the holding circuit board (3) is mounted uprightly on said circuit board (2) and only spaces between individual wiring patterns of the holding circuit board are at least partially coated with an insulating material (6).

2. A circuit board in combination with a separate holding circuit board, said holding circuit board (3) having a plurality of surge absorbing elements (1) mounted on one surface thereof connected through a wire pattern and terminals (5) for mounting said holding circuit board (3) on said circuit board (2), characterized in that the holding circuit board (3) is mounted uprightly on said circuit board (2) and the wire pattern is provided on both surfaces of said holding circuit board (3), whereby the mounting area of surge absorbing elements on the circuit board is reduced.

## Patentansprüche

1. Schaltplatte in Kombination mit einer separaten Halteschaltplatte, wobei die Halteschaltplatte (3) eine Anzahl von Überspannungsschutzelementen (1), die durch ein Leitungsmuster verbunden sind, das auf einer Oberfläche der Platte vorgesehen ist, und Anschlußklemmen (5) aufweist, um die Halteschaltplatte an der Schaltplatte (2) anzubringen, dadurch **gekennzeichnet,** daß die Halteschaltplatte (3) aufrecht auf der Schaltplatte (2) angebracht ist und lediglich Zwischenräume zwischen einzelnen Leitermustern der Halteschaltplatte wenigstens teilweise mit einem Isoliermaterial (6) beschichtet sind.

2. Schaltplatte in Kombination mit einer separaten Halteschaltplatte, wobei die Halteschaltplatte (3) eine Anzahl von Überspannungschutzelementen (1), die an seiner einen Oberfläche angebracht sind, verbunden durch ein Leitungsmuster, und Anschlußklemmen (5) aufweist, um die Halteschaltplatte (3) an der Schaltplatte (2) anzubringen, dadurch **gekennzeichnet,** daß die Halteschaltplatte (3) aufrecht auf der Schaltplatte (2) angebracht ist und das Leitermuster auf beiden Seiten der Halteschaltplatte (3) vorgesehen ist, wodurch die Montagefläche der Überspannungssschutzelemente auf der Schaltplatte verringert ist.

## Revendications

1. Carte de circuit associée à une carte de support séparée, ladite carte de support (3) portant une pluralité d'éléments (1) d'absorption des surtensions reliés par un dessin de câblage placé sur une face de ladite carte, et des bornes (5) pour monter ladite carte de support sur ladite carte imprimée (2), caractérisée en ce que ladite carte de support (3) est montée droite sur ladite carte imprimée (2) et seuls les espaces entre les dessins de câblage individuels de la carte de support sont au moins partiellement recouverts d'un matériau isolant (6).

2. Carte associée à une carte de support séparée, ladite carte de support (3) ayant une pluralité d'éléments (1) d'absorption des surtensions montés sur une de ses faces, reliés par un dessin de câblage, et des bornes (5) pour monter ladite carte de support (3) sur ladite carte imprimée (2), caractérisée en ce que ladite carte de support (3) est montée droite sur ladite carte imprimée (2) et le dessin de câblage est placé sur les deux faces de ladite carte de support (3), si bien que la surface de montage des éléments d'absorption des surtensions sur la carte est réduite.
